# FASCICULE DE BREVET EUROPEEN

(11) **EP 3 260 511 B1**
(45) Date de publication et mention de la délivrance du brevet: **11.08.2021**
(21) Numéro de dépôt: 17177429.2
(22) Date de dépôt: 22.06.2017
(51) Int. Cl.: C09J 7/00

(54) **PROCEDE DE COLLAGE REVERSIBLE ENTRE DEUX ELEMENTS**
REVERSIBLES KLEBEVERFAHREN ZWISCHEN ZWEI ELEMENTEN
REVERSIBLE BONDING METHOD BETWEEN TWO ELEMENTS

(30) Priorité: 24.06.2016 FR 1655914
(43) Date de publication de la demande: 27.12.2017
(73) Titulaire: Commissariat à l'énergie atomique et aux énergies alternatives, 75015 Paris (FR)
(72) Inventeur: BEDJAOUI, Messaoud, 38340 VOREPPE (FR); POULET, Sylvain, 38600 FONTAINE (FR)
(74) Mandataire: Brevalex

(56) Documents cités:
- WO-A2-2014/037792
- FR-A1- 2 796 491
- FR-A1- 2 823 599

## Description

### DOMAINE TECHNIQUE ET ART ANTÉRIEUR

L'invention concerne un procédé de collage réversible entre deux éléments, mis en œuvre en particulier entre deux substrats dont l'un est fin et utilisé comme support de réalisation de dispositifs microélectroniques. Ce procédé s'applique avantageusement lorsque la réalisation des dispositifs microélectroniques implique la mise en œuvre d'étapes à hautes températures (supérieures ou égale à environ 400°C), par exemple lorsque ces dispositifs correspondent à des micro-batteries au lithium.

L'avènement des objets connectés et intelligents est continuellement en quête de dispositifs microélectroniques avec des formes et des contraintes de plus en plus complexes. Outre les problématiques intrinsèques aux composants eux-mêmes, l'introduction de substrats fins (épaisseur inférieure à environ 500 µm) et ultrafins (épaisseur inférieure à environ 100 µm, voire inférieure à environ 50 µm) comme supports de réalisation des dispositifs microélectroniques jouent un rôle primordial.

Néanmoins, les substrats fins et ultrafins sont des substrats extrêmement fragiles au regard de la multiplication et de l'enchaînement d'une multitude d'étapes technologiques nécessaires à la réalisation des circuits électroniques et microélectroniques sur ces substrats.

Une des solutions pour répondre à ce problème de fragilité consiste à coller ces substrats fins et ultrafins sur des substrats rigides épais compatibles avec les procédés classiques de la microélectronique.

Une première méthode de collage dite de collage direct, ou collage moléculaire, a été introduite de façon industrielle notamment pour l'élaboration des substrats SOI (silicium sur isolant, ou « Silicon On Insulator »). Elle consiste à mettre en contact direct, sans emploi de couche intermédiaire, deux éléments caractérisés par deux surfaces de collage suffisamment préparées en termes de planéité et de contamination particulaires et organiques.

Par exemple, le document FR 2 893 750 décrit la mise en œuvre d'un collage direct entre un substrat en verre fin et un substrat rigide épais servant de support. Après des étapes technologiques de réalisation des dispositifs microélectroniques sur le substrat de verre fin, la séparation du substrat de verre fin vis-à-vis du substrat épais est accomplie mécaniquement par l'insertion d'une lame entre les deux substrats collés.

Cette technique trouve toutefois ses limites notamment dans le cas des substrats servant à la réalisation de dispositifs microélectroniques dont la réalisation impose la mise en œuvre d'étapes impliquant des budgets thermiques importants, comme par exemple le dépôt de couches actives. A titre d'exemple, la réalisation de micro-batteries au lithium nécessite la mise en œuvre de recuits thermiques des électrodes à des températures à environ 600°C pendant plusieurs heures. Or, l'énergie de collage des assemblages obtenus par collage direct, sans couche intermédiaire, peut sensiblement augmenter lorsque ces assemblages sont exposés à de telles températures, ce qui engendre un collage permanent des surfaces collées qui ne peuvent plus être séparées l'une de l'autre sans dommage. De plus, la séparation des substrats nécessite l'emploi d'outils mécaniques en frottement avec ces substrats, ce qui peut engendrer des fragilités mécaniques localisées conduisant à une rupture de ces substrats ainsi que des composants réalisés sur ces substrats.

Une séparation réalisée exclusivement par action mécanique via l'insertion d'une lame présente un fort risque d'endommagement des substrats, notamment pour les substrats fragiles très fins, par exemple formés de verre de moins de 100 microns d'épaisseur.

La technique du collage intermédiaire est une technique alternative de fixation de deux éléments pour pallier à certains inconvénients du collage direct, permettant notamment une désolidarisation plus facile entre les éléments. Cette technique de collage emploie généralement une ou plusieurs couches intermédiaires, comportant par exemple des polymères adhésifs, disposées entre les deux surfaces à solidariser.

Le document US 2011/0048611 A1 décrit une méthode de collage d'un substrat sur un substrat épais par l'intermédiaire d'une couche adhésive élastomère et une méthode de séparation des substrats par voie chimique au cours de laquelle la couche adhésive est détruite par trempage de l'assemblage dans un bain à ultrasons.

Cette méthode de séparation des substrats nécessite toutefois une protection accrue des composants présents sur l'assemblage afin d'empêcher toute dégradation dans le bain à ultrasons.

D'autre part, ce type de collage, faisant appel notamment à des polymères en tant que matériaux adhésifs, est incompatible avec la réalisation de dispositifs microélectroniques qui nécessitent l'emploi de procédés hautes températures (supérieures à environ 400°C) en raison de la faible tenue thermique des matériaux adhésifs utilisés.

Une désolidarisation par action chimique et/ou excitation micro-onde nécessite d'utiliser des fluides, ce qui demande de réaliser au préalable des cavités et/ou des canaux d'écoulement sur l'un des éléments collés.

L'utilisation d'une solution acide telle qu'une solution de HF lors de la désolidarisation est très préjudiciable pour certains substrats tels que les substrats de verre, et impose l'emploi d'une protection complète du substrat qui comprend des dispositifs microélectroniques afin que la solution acide attaque l'oxyde de collage sans dégrader les substrats collés l'un à l'autre. Enfin, l'utilisation de micro-ondes engendre une fragilisation de certains substrats tels que les substrats de verre d'épaisseur inférieure à 100 microns.

### EXPOSÉ DE L'INVENTION

Un but de la présente invention est de proposer un procédé de collage réversible entre deux éléments, par exemple deux substrats, qui ne présentent pas les inconvénients des procédés de collage de l'art antérieur, c'est-à-dire formant un assemblage des deux éléments qui soit compatible avec la mise en œuvre d'étapes impliquant des budgets thermiques importants, par exemple à des températures supérieures ou égales à environ 400 °C, quelle que soit la nature des matériaux des éléments, qui ne nécessite pas l'emploi de moyens de séparation mécaniques pouvant endommager les éléments solidarisés, et qui ne nécessite pas une protection particulière des éléments et/ou des composants pouvant être réalisés sur les éléments assemblés ni de préparation particulière telle que la réalisation de canaux d'écoulement ou la fonctionnalisation des surfaces à solidariser.

Pour cela, l'invention propose un procédé de collage réversible entre un premier élément et un deuxième élément, comportant au moins la mise en œuvre des étapes suivantes :
a) réalisation d'au moins une couche d'oxyde sur au moins une première face du premier élément et/ou sur au moins une première face du deuxième élément ;
b) solidarisation de la première face du premier élément avec la première face du deuxième élément telle que la couche d'oxyde forme une interface de collage entre le premier élément et le deuxième élément ;
c) désolidarisation du deuxième élément vis-à-vis du premier élément par l'application d'un traitement thermique sous atmosphère humide contrôlée dégradant physiquement et/ou chimiquement la couche d'oxyde.

Ce procédé fait appel à une ou plusieurs couches intermédiaires formant l'interface de collage entre les premier et deuxième éléments. Ainsi, même si l'assemblage formé des deux éléments solidarisés l'un à l'autre est exposé à des températures importantes, par exemple supérieures ou égales à environ 400°C, l'énergie de collage n'est pas modifiée au point d'engendrer un collage permanent des deux éléments.

De plus, l'interface de collage est formée par au moins une couche d'oxyde qui ne présente pas les inconvénients des couches adhésives à base de polymères. En effet, une telle couche d'oxyde présente une bonne tenue en température dans le cas d'exposition de cette couche à des étapes servant à la réalisation de composants microélectroniques impliquant des budgets thermiques importants telles que le dépôt de couches actives par exemple par PVD (« Physical Vapor Deposition », ou dépôt physique en phase vapeur) ou CVD (« Chemical Vapor Deposition », ou dépôt chimique en phase vapeur).

Par contre, une telle couche d'oxyde a également pour propriété de se dégrader physiquement et/ou chimiquement lorsque celle-ci est exposée à certains traitements thermiques particuliers tels qu'un traitement thermique sous atmosphère humide (qui engendre une modification de la rugosité de la couche d'oxyde conduisant à un effritement de celle-ci) et/ou un chauffage par rayonnement laser (qui engendre une ablation de la couche d'oxyde). C'est cette propriété propre aux oxydes qui est utilisée pour réaliser la désolidarisation des deux éléments.

L'emploi d'un traitement thermique pour désolidariser les deux éléments permet également d'éviter l'emploi systématique de moyens de séparation mécanique qui peuvent dans certains cas endommager les éléments solidarisés.

Enfin, aucune protection particulière n'est imposée par la mise en œuvre du traitement thermique puisque ce traitement ne dégrade que la couche d'oxyde.

Le procédé proposé ici ne suppose pas nécessairement une préparation préalable des surfaces des deux éléments à coller (canaux d'écoulement, fonctionnalisation de surface pour modifier la rugosité ou le caractère hydrophile). Les structures proposées sont compatibles avec les applications hautes températures quelle que soit la nature des éléments utilisés (silicium, verre ou autre). Le procédé de démontage par chaleur humide ne présente pas de risque de dégradation des deux éléments, garantissant ainsi, lorsque les éléments sont des substrats, une intégrité des dispositifs microélectroniques indépendamment de l'épaisseur du substrat d'accueil et une réutilisation du substrat support contrairement aux procédés standards de démontage (action mécanique, action chimique fluidique).

La température et la durée pendant laquelle le traitement thermique est mis en œuvre sont ajustées pour dégrader suffisamment la couche d'oxyde afin de permettre une désolidarisation des deux éléments. Ces paramètres sont adaptés notamment en fonction des différentes caractéristiques de l'interface de collage : nature de l'oxyde utilisé, épaisseur de la couche d'oxyde, accessibilité de la couche d'oxyde, présence d'éventuels autres éléments dans l'interface de collage, etc.

La désolidarisation du deuxième élément vis-à-vis du premier élément est obtenue par l'application d'un traitement thermique sous atmosphère humide contrôlée, par exemple une atmosphère dans laquelle l'humidité relative est supérieure à environ 50 %, ou supérieure à environ 80 % ou supérieure à environ 90 %. Le contrôle de cette atmosphère peut porter au moins sur le taux d'humidité relative auquel les éléments.

Le procédé peut être tel que :
- le premier élément et/ou le deuxième élément correspond à un substrat, et/ou
- le premier élément et/ou le deuxième élément comporte du verre et/ou un semi-conducteur (par exemple du silicium) et/ou une céramique, et/ou
- le premier élément a une épaisseur supérieure ou égale à environ 500 µm, et/ou
- le deuxième élément a une épaisseur inférieure à environ 500 µm.

Le premier élément et/ou le deuxième élément peut correspondre à un substrat qui peut comporter ou non des éléments ou composants microélectroniques reportés et/ou fabriqués à partir de ce substrat. Le terme « substrat » désigne tout type de support, y compris un wafer, ou plaquette, ou un feuillard.

De manière avantageuse, l'un des éléments (par exemple le premier élément) peut-être un support épais qui est plein ou évidé ou encore perforé par exemple par plusieurs trous, et l'autre des éléments peut-être un support fin en particulier adapté pour la réalisation de dispositifs microélectroniques tels que par exemple des micro-batteries.

Le procédé peut comporter en outre, avant l'étape a), la réalisation d'au moins une ouverture à travers le premier élément et/ou le deuxième élément.

La présence d'au moins une ouverture traversant le premier élément et/ou le deuxième élément permet d'augmenter la surface de l'interface de collage accessible lors du traitement thermique de l'étape c) dégradant la couche d'oxyde, ce qui permet de réduire la durée nécessaire à la dégradation de la couche d'oxyde.

Le procédé peut comporter en outre, entre les étapes b) et c), la mise en œuvre d'une étape de traitement du premier élément et/ou du deuxième élément.

L'étape de traitement peut comporter la réalisation d'au moins une partie d'au moins un dispositif microélectronique sur le deuxième élément et/ou sur le premier élément. En outre, l'étape de traitement peut être mise en œuvre à une température supérieure ou égale à environ 400°C, et peut correspondre notamment à une étape de dépôt de couches actives d'un ou plusieurs dispositifs microélectroniques.

Le dispositif microélectronique réalisé peut correspondre à un dispositif de stockage d'énergie, par exemple un micro-batterie et plus particulièrement une micro-batterie au lithium, et/ou un dispositif de récupération d'énergie, par exemple une cellule photovoltaïque et plus particulièrement une cellule photovoltaïque organique, et/ou un dispositif d'affichage, par exemple une diode électroluminescente et plus particulièrement une diode électroluminescente organique (ou OLED pour « Organic Light-Emitting Diode ») et/ou un capteur et/ou un actionneur.

D'une manière générale, le domaine d'application de ce procédé couvre une large gamme de dispositifs microélectroniques confrontés aux contraintes de maniement des substrats fragiles au regard des procédés microélectroniques. Ainsi, ce procédé peut être adapté à d'autres dispositifs microélectroniques tout en respectant les spécificités de chaque application.

La couche d'oxyde peut :
- comporter de l'oxyde d'aluminium, également appelé alumine, et/ou de l'oxyde de titane et/ou de l'oxyde de zirconium et/ou de l'oxyde de zinc et/ou de l'oxyde de silicium (ou plus généralement un oxyde métallique et/ou un oxyde diélectrique), et/ou
- être déposée sur toute les surfaces du premier élément et/ou du deuxième élément, et/ou
- avoir une épaisseur inférieure ou égale à environ 100 nm, et/ou
- être déposé par dépôt de couches atomiques à partir d'au moins un précurseur organométallique et un précurseur comportant des molécules d'eau.

Le traitement thermique peut être mis en œuvre sous atmosphère humide et/ou peut comporter un chauffage par rayonnement laser de la couche d'oxyde par exemple à travers l'un des premier et deuxième éléments.

Une atmosphère humide peut correspondre à une atmosphère dans laquelle l'humidité relative est supérieure à environ 50 %.

Le traitement thermique peut comporter un chauffage par rayonnement laser de la couche d'oxyde à travers l'un des premier et deuxième éléments, ledit un des premier et deuxième éléments pouvant être transparent vis-à-vis du rayonnement laser.

Dans ce cas, l'autre des premier et deuxième éléments peut comporter au moins une couche apte à réfléchir et/ou absorber le rayonnement laser.

Le procédé peut comporter en outre :
- avant l'étape b), la mise en œuvre d'un traitement plasma, et/ou
- entre les étapes b) et c), la mise en œuvre d'un traitement thermique renforçant l'énergie de collage entre le premier élément et le deuxième élément, et/ou
- avant l'étape c), l'application d'un champ électrostatique sur le premier élément et/ou le deuxième élément.

Le traitement thermique renforçant l'énergie de collage entre le premier élément et le deuxième élément peut être mis en œuvre à une température inférieure à environ 400°C. De manière alternative, ce traitement thermique peut être mis en œuvre à une température supérieure à environ 400°C suivant la nature de l'oxyde utilisé pour former l'interface de collage, si les éléments sont compatibles avec une telle température. La durée du traitement thermique est adaptée en fonction de la température avec laquelle ce traitement est mis en œuvre.

La désolidarisation du deuxième élément vis-à-vis du premier élément peut comporter en outre l'application d'une action mécanique et/ou d'un jet de gaz sous pression entre les premier et deuxième éléments. Cette action mécanique et/ou ce jet de gaz sous pression sont dans ce cas utilisés comme assistance au traitement thermique dégradant la couche d'oxyde.

Les dimensions de la première face du premier élément peuvent être supérieures ou égale à celles de la première face du deuxième élément.

Le procédé s'applique par exemple pour la réalisation de micro-batteries solides au lithium sur des substrats en verre fins ou ultrafins préalablement fixés sur des substrats rigides épais.

Selon un mode de réalisation avantageux, le procédé peut comporter les étapes successives suivantes :
- préparer un premier substrat épais (épaisseur supérieure à environ 500 µm) traversé par des trous débouchant sur les deux surfaces principales du premier substrat ;
- procéder à un dépôt d'une ou plusieurs couches d'oxyde d'aluminium sur le premier substrat de façon à couvrir correctement et de manière homogène au moins l'une des surfaces du premier substrat ;
- reporter un deuxième substrat en verre fin ou ultrafin sur le premier substrat par mise en contact d'une première face du deuxième substrat avec l'une des faces du premier substrat préalablement couverte d'oxyde d'aluminium afin de réaliser un collage entre les deux substrats ;
- fabriquer plusieurs dispositifs microélectroniques sur la deuxième face libre du deuxième substrat ;
- exposer l'assemblage réalisé à un environnement contrôlé en humidité et en température de façon à fritter la ou les couches d'oxyde d'aluminium et désolidariser le deuxième élément vis-à-vis du premier élément.

L'ajustement des paramètres de l'environnement auquel l'assemblage est exposé permet de mieux gérer le procédé d'effritement de la ou des couches d'oxyde d'aluminium.

D'une manière générale, les couches d'oxyde sont utilisées dans les dispositifs microélectroniques pour remplir plusieurs fonctionnalités et particulièrement l'encapsulation des éléments sensibles à l'air comme dans le cas des micro-batteries au lithium. Cependant, le procédé décrit ici se base sur le fait qu'une exposition de ces couches d'oxyde à des budgets thermiques adéquats (par exemple une chaleur humide et/ou une irradiation laser) engendre une dégradation physique et/ou chimique desdites couches. C'est cette propriété de dégradation non désirée pour les applications conventionnelles qui est exploitée dans le démontage des assemblages élaborés selon le procédé décrit ici.

L'une des applications visées par la présente invention concerne particulièrement la réalisation de dispositifs microélectroniques légers et souples sur un substrat final d'une épaisseur inférieure à environ 100 µm. Pour s'affranchir des contraintes mécaniques liées à la fragilité du substrat final, les substrats finaux souples et fragiles sont reportés sur des substrats initiaux rigides compatibles avec les procédés microélectroniques tout en disposant aisément des substrats fragiles supportant les dispositifs microélectroniques.

Il est proposé une structure comprenant deux substrats et obtenue par un procédé de collage réversible caractérisé par la réalisation d'une interface de collage démontable. Le procédé proposé combine les avantages du collage direct et du collage intermédiaire. La fixation du substrat fragile sur un substrat rigide est réalisée sans emploi de polymère adhésif. Ainsi, il est possible d'obtenir l'assemblage par la mise en contact de l'une des surfaces du substrat fragile avec l'une des deux surfaces du support rigide via l'interface de collage. Cette mise en contact peut par exemple être réalisée par un procédé de laminage standard.

De manière avantageuse et avant de procéder aux opérations de collage, les surfaces du substrat initial peuvent être entièrement recouvertes de couches d'oxyde d'aluminium.

D'autre part, l'énergie de collage de l'assemblage obtenu peut être aisément augmentée par un prétraitement plasma des surfaces de collage ou par un post traitement thermique à faible température (par exemple inférieure à environ 400°C) pendant plusieurs heures. De même, il est possible d'améliorer l'énergie de collage par l'application d'une décharge électrostatique sur l'une des surfaces de collage ou bien sur l'une des deux faces extérieures de l'assemblage réalisé.

Selon l'une des options possibles, l'assemblage obtenu par collage peut potentiellement être utilisé comme système convoyeur dans la fabrication d'une multitude de dispositifs microélectroniques faisant appel à des procédés complexes. En particulier, il est possible de se servir de ces assemblages en dépit des étapes technologiques basées sur des budgets thermiques importants (une température supérieure à environ 400°C appliquée pendant une ou plusieurs heures) contrairement aux techniques de collage à base de polymères décrites dans l'état de l'art antérieur. C'est notamment le cas des dispositifs électrochimiques type micro-batteries au lithium dont les couches d'électrodes (plus particulièrement l'oxyde de cobalt) nécessitent parfois des recuits d'activation électrochimiques à une température d'environ 600°C pendant au moins deux heures. Ce type d'applications suppose l'utilisation de matériaux de substrats (fragile et rigide) avec des coefficients d'expansion thermique (CET) très proches pour prévenir les problèmes mécaniques lors du procédé de post recuit.

En dehors de l'intérêt des post recuits dans la formation des couches actives des dispositifs fabriqués, les assemblages obtenus présentent un avantage majeur dans l'amélioration de l'énergie de collage rendant de ce fait l'assemblage comprenant le substrat fragile et le substrat rigide plus robuste en vue d'enchaîner les autres étapes technologiques.

D'une manière générale, la ou les couches d'oxyde peuvent être déposées à faible température (par exemple inférieure à environ 400°C) et avec une très faible épaisseur (épaisseur totale inférieure ou égale à environ 100 nm) par des techniques de dépôt couches minces. Préférentiellement, l'emploi de la technique de dépôt des couches atomiques (ALD pour « Atomic Layer Deposition ») qui mélange de manière séquentielle un précurseur organométallique, par exemple du trimethylaluminium (TMA) lorsque la couche d'oxyde comporte de l'alumine, avec un précurseur de vapeur d'eau (H₂O) permet de réaliser des films d'oxyde de très haute pureté et de très faible épaisseur.

Alternativement, la ou les couches d'oxyde peuvent être obtenues par un procédé ALD assisté par plasma appelé PEALD (« Plasma Enhanced Atomic Layer Déposition »).

La composition de l'oxyde obtenu peut être parfaitement stœchiométrique (Al₂O₃ dans le cas de l'alumine) ou bien sous stœchiométrique (Al_{X}O_{Y}H_{Z} dans le cas de l'alumine).

Initialement, c'est-à-dire avant l'application du traitement thermique dégradant la couche d'oxyde, cette ou ces couches d'oxyde sont caractérisées par une très faible rugosité, par exemple inférieure à environ 0,1 nm RMS (« Root Mean Square ») et une surface très hydrophile. Avantageusement, ces caractéristiques assurent une forte énergie de collage entre les deux éléments. En effet, le caractère hydrophile des surfaces d'oxyde et la présence des molécules d'eau dans le procédé de fabrication des films d'oxyde avantage particulièrement les forces attractives, notamment les forces de Van der Waals, entre les deux surfaces de collage des deux éléments. Ce mode de collage est favorisé par la formation de liaisons hydrogène entre les deux surfaces de collage assurant ainsi une très forte énergie de collage.

Le matériau de la couche d'oxyde, notamment l'oxyde d'aluminium, réalisé à basse température (inférieure à environ 400°C) peut être un oxyde amorphe avec une teneur en hydrogène relativement forte. Cette concentration d'hydrogène peut être ajustée en fonction des conditions opératoires d'élaboration des couches, notamment la température de dépôt. Ce phénomène est plus prononcé pour les couches d'oxyde réalisés à des températures inférieure à environ 150°C (par exemple avec une épaisseur inférieure ou égale à environ 50 nm) dont la teneur en hydrogène est très importante par rapport aux films réalisés à des températures supérieures à environ 150°C. Bien que les liaisons hydrogènes présentent un intérêt dans le renforcement de l'énergie de collage des d'assemblages réalisés, elles sont en revanche à l'origine de la destruction des couches d'oxyde. Le pourcentage atomique d'hydrogène dans le matériau de la couche d'oxyde peut être supérieur à environ 5 %, et de préférence compris entre environ 5 % et 20 %.

En effet, les couches d'oxyde exposées de manière prolongée (de quelques minutes à quelques centaines d'heures) à un environnement agressif, par exemple formé par un très fort taux de vapeur d'eau (entre 90 % et 100 % d'humidité relative) et une température de l'ordre de 100°C, sont caractérisées par une très forte rugosité de surface (supérieure à environ 10 nm RMS) par rapport à la couche d'oxyde initiale (rugosité inférieure à environ 0,1 nm RMS). De plus, cette modification de l'état de surface est accompagnée par un effritement, ou éclatement, de la couche d'oxyde engendrant une très forte dégradation de ladite couche, conduisant à un démontage de l'interface de collage. C'est cette caractéristique d'effritement des couches d'oxyde qui peut être exploitée dans la désolidarisation des éléments par voie chimique mise en œuvre.

Le premier élément peut être caractérisé par la présence de trous qui débouche sur l'interface de collage et agencés au sein du premier élément de façon à augmenter la surface totale à recouvrir par les couches d'oxyde sans perturber les propriétés de collage. Cette architecture présente l'avantage de multiplier les canaux de drainage et d'infiltration de la vapeur d'eau lors du démontage de l'interface de collage après exposition.

De manière avantageuse, les trous ou drains traversant le premier élément peuvent être de taille micrométrique et être espacés d'une centaine de microns les uns aux autres, constituant ainsi des structures avec des drains caractérisés par des rapports de structure supérieurs ou égaux à 1. De façon générale, les caractéristiques géométriques des drains formés dans le premier élément peuvent être ajustées afin de mieux réguler la vitesse de dégradation de la couche d'oxyde, et le cas échéant le démontage de l'interface de collage.

Optionnellement, le procédé de séparation des éléments peut être assisté par une action mécanique, telle que l'insertion d'une lame ou d'un coin au niveau de l'interface de collage, pour mieux appréhender l'élément qui supporte les dispositifs microélectroniques. Selon une autre variante, l'action d'assistanat lors du procédé de séparation des substrats peut être obtenue par un jet pressurisé d'air sec, d'azote, d'argon, d'hélium ou encore d'eau.

Le principe de base de la séparation du deuxième élément vis-à-vis du premier élément peut être de démonter chimiquement l'interface de collage sans dégradation des éventuels dispositifs microélectroniques disposés sur le deuxième élément tout en préservant l'intégrité du premier élément pour une éventuelle réutilisation.

Dans un mode de réalisation avantageux, l'exposition des couches d'oxyde présentes à l'interface de collage à un environnement agressif en humidité et en température engendre un effritement desdites couches permettant de désolidariser les éléments. L'oxyde utilisé au niveau de l'interface de collage peut correspondre à tout oxyde ou toute combinaison d'oxydes caractérisé par une teneur en hydrogène suffisante pour réaliser le collage entre les éléments et le démontage de l'interface de collage par exposition à un milieu agressif en humidité et en température. C'est par exemple le cas des oxydes métalliques, telles que l'oxyde de titane, l'oxyde de zirconium ou l'oxyde de zinc, et les oxydes diélectriques, telles que l'oxyde de semi-conducteur, par exemple l'oxyde de silicium, ou l'oxyde de nitrure (par exemple un mélange de nitrure et de silice sous forme chimique SiO_{X}N_{Y}H_{Z}). Ces matériaux employés de façon unitaire ou par combinaison peuvent être obtenus par des procédés de dépôts sous vide tels que l'ALD, le PEALD ou le CVD.

La couche d'oxyde peut être géométriquement limitée par la surface du premier élément et/ou du deuxième élément sur laquelle elle est déposée.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 6 représentent les étapes d'un procédé de collage réversible de deux éléments entre eux, objet de la présente invention, selon un premier mode de réalisation ;
- la figure 7 représente une variante de réalisation d'un premier substrat collé de manière réversible à un deuxième substrat par la mise en œuvre d'un procédé de collage réversible, objet de la présente invention, selon un deuxième mode de réalisation ;
- la figure 8 représente un assemblage obtenu lors de la mise en œuvre d'un procédé de collage réversible, objet de la présente invention, selon un troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

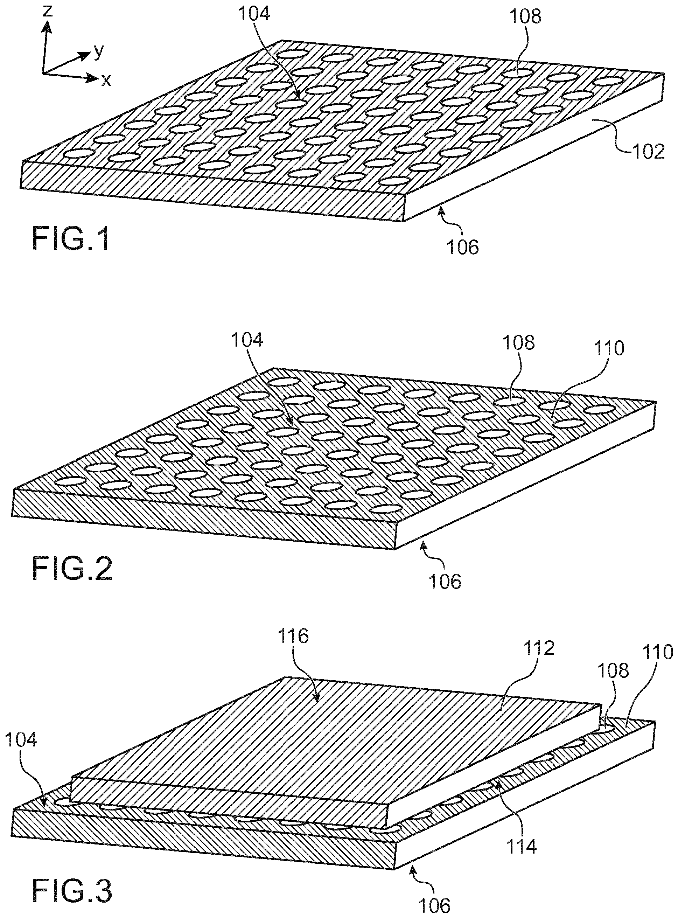

Un procédé de collage réversible entre deux éléments selon un premier mode de réalisation est décrit ci-dessous en lien avec les figures 1 à 6.

Un premier des deux éléments destinés à être collés de manière réversible, ou temporairement, l'un à l'autre correspond à un premier substrat 102 tel que représenté sur la figure 1. Ce premier substrat 102 comporte ici du verre et son épaisseur (dimension parallèle à l'axe Z sur la figure 1) est supérieure ou égale à environ 500 µm. Sur l'exemple de la figure 1, le premier substrat 102 a une forme rectangulaire telle que les deux faces principales (ou faces de plus grandes dimensions) 104, 106 du premier substrat 102 aient chacune des dimensions égales à environ 12 cm x 15 cm dans le plan (X,Y). Le premier substrat 102 forme un substrat épais rigide destiné à servir de support à l'autre élément destiné à être collé de manière réversible sur celui-ci.

Le premier substrat 102 comporte par exemple du verre borosilicaté sans alcali ou encore du verre boro-alumino-silicaté-alcalino-terreux issu de terres rares alcalines.

En variante, la forme et/ou le matériau du premier substrat 102 peuvent être différents. Par exemple, le premier substrat 102 peut comporter un semi-conducteur tel que du silicium, ou bien une céramique.

Une préparation de ce premier substrat 102 est tout d'abord mise en œuvre.Cette préparation comporte la réalisation de trous (ou drains) 108 à travers toute l'épaisseur du premier substrat 102. Les trous 108 débouchent donc sur les faces principales 104, 106. Dans l'exemple de réalisation représenté sur la figure 1, les trous 108 ont ici chacun, dans le plan principal du premier substrat 102 (parallèle au plan (X,Y)), une section en forme de disque (chaque trou 108 ayant donc une forme cylindrique) de diamètre égal à environ 10 µm. Les trous 108 sont espacés les uns des autres d'une distance égale à environ 500 µm. La rapport entre la valeur de la distance séparant deux trous 108 voisins et la valeur de la dimension de la section d'un des trous 108, appelé rapport de structure, ici égal à environ 50.

De manière générale, les trous 108 sont réalisés de préférence avec un rapport de structure supérieur à 1.

Les trous 108 peuvent être obtenus soit par la mise en œuvre d'un procédé chimique de gravure sélective du matériau du premier substrat 102, soit par ablation laser.

De façon préférentielle, les trous 108 sont usinés par tout type de laser choisi en fonction des propriétés optiques du matériau du premier substrat 102. Il peut s'agir par exemple d'un laser impulsionnel émettant dans l'ultraviolet (par exemple un laser à excimères, ou YAG), ou dans le proche infrarouge ou encore dans l'infrarouge lointain. Par exemple, dans le cas d'un premier substrat 102 comportant du verre boro-alumino-silicaté sans alcali et d'épaisseur égale à environ 500 µm, une source laser CO₂ ayant une longueur d'onde d'émission égale à environ 10,64 µm et utilisée à une puissance d'environ 20 Watts peut être utilisée pour former les trous 108.

En variante, les trous 108 peuvent être réalisés par la mise en œuvre de techniques de photo-lithogravure chimique. Dans ce cas, le premier substrat 102 est tout d'abord protégé par une résine photosensible sauf au niveau des zones qui correspondent aux emplacements des trous 108, en utilisant des masques dédiés. La gravure des trous 108 s'effectue ensuite dans une solution aqueuse, comprenant par exemple de l'hydroxyde de sodium (NaOH) ou préférentiellement une solution à base d'acide fluorhydrique (HF).

La réalisation des trous 108 est suivie par un procédé de nettoyage chimique du premier substrat 102 afin d'éliminer les résidus particulaires de gravure ainsi que toute contamination organique potentielle, et conférer une planéité quasi-parfaite (rugosité inférieure à environ 1 nm RMS) à la surface du premier substrat 102 destinée à être solidarisée au deuxième élément, c'est-à-dire ici la surface de la première face principale 104. Le procédé de nettoyage consiste par exemple à tremper tout d'abord le premier substrat 102 dans des bains de détergents (savon) et d'ultrasons (deux minutes), puis à mettre en œuvre plusieurs opérations de rinçage à l'eau DI (eau dé-ionisée) et de procéder au séchage sous air des surfaces du premier substrat 102. Les opérations de nettoyage/rinçage/séchage peuvent être répétées plusieurs fois jusqu'à élimination totale des résidus.

La surface du premier substrat 102 destinée à être solidarisée au deuxième élément est ensuite préparée au collage.

Dans le premier mode de réalisation décrit ici, cette préparation consiste ici à couvrir toute la surface du premier substrat 102, c'est-à-dire la surface de la première face principale 104 mais également celles de la deuxième face principale 106, des faces latérales du premier substrat 102 (celles perpendiculaires aux faces principales 104, 106) ainsi que les surfaces exposées dans les trous 108, par une ou plusieurs couches d'oxyde 110 destinée à former l'interface de collage entre le premier substrat 102 et le deuxième élément (voir figure 2). Dans ce premier mode de réalisation, une couche 110 d'oxyde d'aluminium, ou d'alumine, est formée en surface du premier substrat 102.

La couche 110 est ici déposée par ALD à partir d'un précurseur organométallique, par exemple du TMA, et d'un précurseur co-réactif, par exemple de l'eau dé-ionisée ou de la vapeur d'eau (H₂0). Les précurseurs sont introduits séquentiellement dans l'équipement de dépôt utilisé, en commençant préférentiellement par le précurseur organométallique, et en respectant un temps d'attente avant la purge des résidus de la réaction. Le temps d'attente représente le temps de présence des espèces de réaction (précurseurs organométalliques + précurseurs co-réactifs) dans les trous 108 du premier substrat 102. Il est directement proportionnel à la valeur du rapport de structure caractérisant les dimensions et la densité avec lesquelles les trous 108 sont réalisés dans le premier substrat 102. A titre d'exemple, le temps d'attente peut atteindre environ 100 secondes pour des trous 108 avec un rapport de structure égal à environ 1500.

De manière alternative, la couche 110 peut être déposée par PEALD.

La composition de la couche d'alumine 110 obtenue par ALD à faible température de dépôt (inférieure à environ 400°C) peut être parfaitement stœchiométrique (Al₂O₃) ou bien sous stœchiométrique (Al_{X}O_{Y}H_{Z}).

Dans le premier mode de réalisation décrit ici, les deux précurseurs (TMA et H₂O) sont tout d'abord introduits l'un après l'autre avec des pulsations d'une durée d'environ 50 ms. Un temps d'attente d'environ 5 s est ensuite respecté. Une opération de purge d'une durée d'environ 10 s est ensuite réalisée. Ces opérations sont reproduites plusieurs fois en fonction du nombre de cycles de dépôt désiré, c'est-à-dire fonction de l'épaisseur souhaitée de la couche 110. Ainsi, il faut par exemple environ 250 cycles tels que décrits ci-dessus pour déposer sur le premier substrat 102 une couche d'alumine 110 d'une épaisseur égale à environ 50 nm.

L'épaisseur totale de cette couche 110 est par exemple comprise entre environ 1 nm et 100 nm, cette épaisseur étant ajustée par le nombre de cycles de dépôt réalisés. Les températures de dépôt sont de préférence comprises entre environ 80°C et 400°C, et avantageusement inférieures à environ 150°C. Dans ce premier mode de réalisation, toutes les surfaces du premier substrat 102 sont recouvertes par la couche d'oxyde d'aluminium 110 qui a une épaisseur d'environ 50 nm obtenue avec la mise en œuvre d'environ 250 cycles de dépôt à une température égale à environ 80°C.

La couche 110 obtenue est caractérisée par une présence d'hydrogène de l'ordre de 18 % exprimée en pourcentage atomique, une densité de l'ordre de 2,65 g/cm³ et une rugosité de surface inférieure à environ 0,3 nm RMS voire même inférieure à environ 0,1 nm RMS.

En variante, seule la surface du premier substrat 102 destinée à être solidarisée au deuxième élément, c'est-à-dire la première face principale 104 du premier substrat 102 dans l'exemple décrit ici, peut être recouverte d'une ou plusieurs couches d'oxyde destinées à former l'interface de collage.

L'étape suivante correspond au collage du premier substrat 102 (recouvert de la couche 110) avec le deuxième élément qui est ici un deuxième substrat 112. Dans ce premier mode de réalisation, le deuxième substrat 112 correspond à un substrat de forme rectangulaire comprenant verre boro-alumino-silicaté sans alcali ultrafin d'épaisseur égale à environ 50 µm et ayant une rugosité inférieure ou égale à environ 1 nm RMS.

Le deuxième substrat 112 comporte par exemple du verre borosilicaté sans alcali ou encore du verre boro-alumino-silicaté-alcalino-terreux issu de terres rares alcalines.

Comme pour le premier substrat 102, la forme et/ou le matériau du deuxième substrat 112 peuvent être différents.

L'une des faces du premier substrat 102, ici la première face principale 104, recouverte par la couche 110 est mise en contact avec une première face principale 114 du deuxième substrat 112. L'interface de collage entre les deux substrats 102, 112 est formée par la couche 110. La mise en contact des deux substrats 102, 112 peut être réalisée par un procédé de laminage dit feuille à feuille (ou « sheet to sheet » en anglais) permettant ainsi de chasser l'air éventuellement emprisonné entre les deux substrats 102, 112 afin de prévenir la formation de bulles. La mise en contact des deux surfaces de verres est ici réalisée par un procédé de laminage adapté (par exemple avec une pression comprise entre environ 1 bar et 3 bars, et vitesse d'environ 0,5 m/mn), ce qui permet au final l'obtention d'un assemblage caractérisé par une énergie de collage supérieure à environ 500 mJ.m⁻² et par exemple de l'ordre de 1 J.m⁻².

Au préalable, le deuxième substrat 112 est nettoyé comme précédemment décrit pour le premier substrat 102. De ce fait, la mise en contact de deux surfaces identiques en termes de planéité permet de réaliser un collage avec une énergie de collage.

Un clampage comportant l'application d'un champ électrostatique sur au moins l'un des deux substrats 102, 112, avant ou après la mise en contact des surfaces des substrats, peut être réalisé pour favoriser le renforcement du collage du deuxième substrat 112 vis-à-vis du premier substrat 102 grâce à la présence d'électrons au niveau des surfaces isolantes, et permettant l'obtention d'une énergie de collage pouvant atteindre environ 1 J.m⁻².

L'énergie de collage obtenue peut également être renforcée en mettant en œuvre, avant le collage des deux substrats 102, 112, un prétraitement plasma des surfaces destinées à être collées, réalisant ainsi une activation de surface augmentant l'énergie de surface par enlèvement de contaminants sur la surface ou par réaction avec ces contaminants. Par exemple, pour une surface d'oxyde de silicium, un plasma de N₂ peut être utilisé.

L'énergie de collage obtenue peut également être renforcée par la mise en œuvre d'un post-traitement thermique, par exemple un recuit sous atmosphère contrôlée de O₂/N₂/Ar ou sous air, à faible température (par exemple inférieure ou égale à environ 400°C) et pendant plusieurs heures (par exemple environ 10 heures) sur l'assemblage obtenu.

L'assemblage des substrats 102 et 112 est facilité lorsque ces substrats comportent un même matériau, par exemple du verre, ou plus généralement des matériaux ayant des CET très proches ou sensiblement égaux (par exemple une différence entre les valeurs des CET qui est inférieure ou égale à environ 10 %). Dans ce cas, la dilatation thermique intrinsèque du deuxième substrat 112 est sensiblement identique à celle du premier substrat 102 lors des procédés technologiques nécessitant une exposition de ces substrats à des températures importantes. Dans l'exemple décrit ici, les caractéristiques thermiques et mécaniques du premier substrat 102 et du deuxième substrat 112 sont quasi-identiques et données respectivement par les valeurs du CTE (3.2x10⁻⁶ K⁻¹) et du module d'Young (74.8 kN/mm²) du verre des premier et deuxième substrats 102, 112.

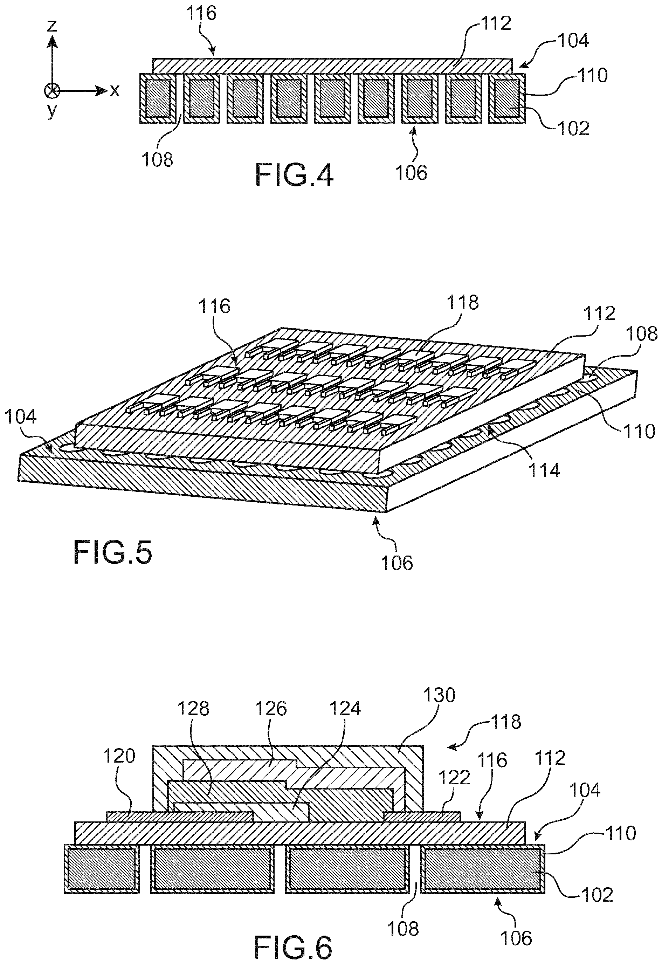

L'assemblage obtenu est représenté sur les figures 3 et 4. La figure 4 correspond à une vue en coupe de l'assemblage obtenu.

Selon la configuration préférentielle telle que représentée sur la figure 3, le deuxième substrat 112 comporte, dans le plan principal du deuxième substrat 112 (plan (X,Y) sur la figure 3) une section telle que la projection de cette section dans le plan de la première face principale 104 du premier substrat 102 soit inscrite dans la section de la première face principale 104. Sur l'exemple de la figure 3, les faces principales 104, 106 du premier substrat 102 ont chacune, dans le plan (X,Y), une forme rectangulaire de dimensions égales à environ 12 cm x 15 cm, et les faces principales 114, 116 du deuxième substrat 112 ont chacune, dans le plan (X,Y), une forme rectangulaire de dimensions inférieures à celles des faces principales 104, 106 du premier substrat 102 et égales à environ 11 cm x 14 cm. Le deuxième substrat 112 est sensiblement centré par rapport au premier substrat 102.

Un clampage est ici réalisé après la mise en contact des deux substrats 102, 112. Une charge haute tension de 5kV à polarité positive est appliquée à la surface du premier substrat 102 couverte par la couche d'oxyde d'aluminium 110 en utilisant un chargeur de haute tension électrostatique. En parallèle, une charge équivalente à polarité inverse est appliquée à la surface du deuxième substrat 112.

Après la solidarisation du deuxième substrat 112 au premier substrat 102, des dispositifs microélectroniques sont ensuite réalisés sur le deuxième substrat 112. Sur l'exemple représenté sur la figure 5, les dispositifs microélectroniques réalisés correspondent à des dispositifs électrochimiques type micro-batteries solides au lithium 118 réalisés sur la deuxième face principale 116 du deuxième substrat 112.

D'une manière générale, une micro-batterie au lithium est obtenue par la mise en œuvre de dépôts des couches minces de type PVD ou CVD. Une vue en coupe d'une des micro-batteries 118 réalisée sur le deuxième substrat 112 est représentée sur la figure 6. La micro-batterie 118 comporte des collecteurs de courant cathodique 120 et anodique 122 métalliques (comprenant par exemple du titane, de l'or, de l'aluminium, du platine, du tungstène ou tout autre métal adapté) disposés sur le deuxième substrat 112 en verre. Les couches actives de la micro-batterie 118 forment les deux cathodes représentées par l'électrode positive 124 (cathode) et l'électrode négative 126 (anode) isolées électriquement l'une de l'autre par un électrolyte ionique 128.

L'électrode positive 124 a une épaisseur comprise entre environ 100 nm et 10 µm, et comporte un matériau ayant une bonne conductivité électronique et ionique (par exemple au moins l'un des matériaux suivants : TiOS, TiS₂, LiTiOS, LiTiS₂, LiCoO₂, V₂O₅, etc.). Le dépôt de ces matériaux est réalisé à des températures qui peuvent dépasser 400°C et nécessite parfois des recuits à très haute température (environ 600°C voire plus) afin d'activer toutes les propriétés électrochimiques de ces matériaux. C'est le cas d'une électrode comprenant du LiCoO₂ déposée à une température d'environ 400°C et recuite à environ 600°C pendant environ 2h. De tels budgets thermiques sont ici avantageux car ils permettent de renforcer le collage entre les premier et deuxième substrats 102, 112, permettant d'atteindre des énergies de collage d'environ 4 J.m⁻².

L'électrolyte 128 a ici une épaisseur comprise entre environ 500 nm et 5 µm et forme un isolant électronique avec une forte conductivité ionique. L'électrolyte 128 comprend par exemple au moins l'un des matériaux suivants : LiPON, LiPONB, LiSiCON.

L'électrode négative 126 correspond à une couche mince d'une épaisseur comprise entre quelques nanomètres et quelques dizaines de microns, et peut être constituée exclusivement de lithium métallique ou d'un matériau sciemment lithié.

Une couche d'encapsulation 130 est présente sur les couches actives 124, 126 et 128 notamment en raison de la très forte réactivité du lithium et des couches lithiées vis-à-vis de l'atmosphère. La couche d'encapsulation 130 peut être réalisée de façon monolithique ou hétérogène. A titre d'exemple, la couche d'encapsulation 130 représentée sur la figure 6 correspond à une couche barrière d'épaisseur égale à environ 25 µm reporté par laminage ou par scellement sur l'ensemble des micro-batteries 118 disposées sur le deuxième substrat 112. La couche d'encapsulation 130 correspond par exemple à des films laminés de type aluminium / PET (Polytéréphtalate d'éthylène) / adhésif.

Le procédé est achevé en réalisant la séparation du deuxième substrat 112 vis-à-vis du premier substrat 102 en dégradant la couche 110.

Cette séparation est ici obtenue par effritement de la couche d'oxyde d'aluminium 110, cet effritement étant la conséquence d'une exposition de la couche 110, au niveau des faces latérales de cette couche 110 et des parties de la couche 110 accessibles depuis les trous 108, à une atmosphère contrôlée en humidité et en température qui engendre une très forte modification de la rugosité de surface de la couche 110. En effet, une exposition prolongée de la couche 110 à un environnement de chaleur humide engendre une modification des propriétés physico-chimiques de l'alumine accompagnée par une augmentation de sa rugosité de surface. Par exemple, une couche d'alumine de 50 nm d'épaisseur déposée par ALD à une température de 80°C exposée pendant quelques heures (par exemple environ 5 heures) à un flux de chaleur humide (100 % d'humidité relative et 100°C) se trouve enrichie par des liaisons pendantes hydroxyles type OH et des liaisons carbonates (CO₃). La rugosité de l'alumine qui est initialement inférieure à environ 0,3 nm RMS après dépôt augmente jusqu'à atteindre des valeurs qui dépassent 100 nm RMS, causant ainsi un effritement important de l'alumine, permettant le détachement des substrats 102, 112 l'un de l'autre.

Lorsque l'assemblage précédemment réalisé est exposé dans un environnement humide tel que décrit ci-dessus, la couche d'encapsulation 130 assure également la protection des dispositifs 118 vis-à-vis de cet environnement. Optionnellement, la séparation des substrats 102, 112 peut être réalisée sous pression contrôlée dans des chambres hermétiques dédiées telles qu'un autoclave.

Cette séparation peut être assistée par un outil mécanique, comme par exemple une lame, permettant d'appréhender aisément le deuxième substrat 112 contenant les dispositifs 118.

Après cette séparation, le premier substrat 102 reste intact et peut être recyclé pour la réalisation d'autres assemblages.

D'autres exemples de matériaux pouvant être utilisés pour former la couche d'oxyde servant d'interface de collage et se dégradant lorsqu'ils sont exposés à une chaleur humide sont :
- l'Al_{X}O_{Y}H_{Z}, qui peut se dégrader lorsqu'il est exposé à une atmosphère dont l'humidité relative est d'au moins 90 % et à une température d'au moins 90°C ;
- le TiO_{X}H_{Y}, qui peut se dégrader lorsqu'il est exposé à une atmosphère dont l'humidité relative est d'au moins 95 % et à une température d'au moins 95°C.

Dans les matériaux cités ci-dessus, les indices X, Y et Z correspondent aux proportions des différents éléments de ces matériaux.

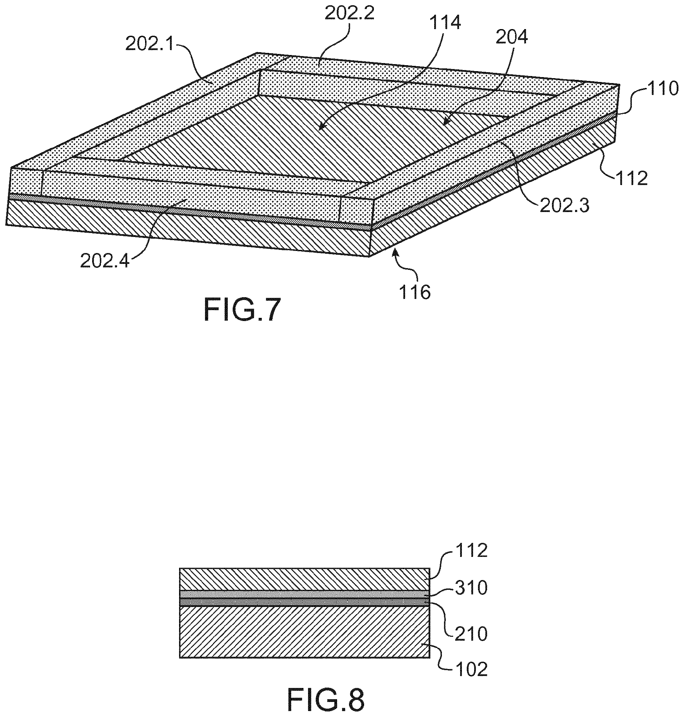

L'un ou les deux éléments 102, 112 solidarisés l'un à l'autre selon le procédé précédemment décrit peuvent ne pas correspondre à des substrats. Ainsi, sur l'exemple représenté sur la figure 7, le premier élément 102 ne correspond pas à une couche de matériau formant un premier substrat comme dans le premier mode de réalisation précédemment décrit, mais à quatre portions de matériau 202.1 - 202.4, comprenant ici du verre, et assemblées les unes aux autres en formant un cadre collé à la couche 110 qui est réalisée au préalable sur la première face principale 114 du deuxième substrat 112. Les portions 202.1 - 202.4 forment une couche traversée par une ouverture 204 formant un accès à la couche 110.

La séparation des deux éléments 102, 112 est réalisée de manière analogue au premier mode de réalisation, avec toutefois un accès plus aisée du flux de chaleur aux parties de la couche 110 formant l'interface de collage dont la surface est réduite par rapport au premier mode de réalisation précédemment décrit. Cela peut se traduire par une exposition moins longue des différents éléments, et notamment les dispositifs 118, à l'environnement utilisé pour désolidariser les deux éléments 202, 112 et qui peut être agressif et endommager les dispositifs 118.

En outre, dans le premier mode de réalisation précédemment décrit, les dimensions du deuxième substrat 112 et le positionnement du deuxième substrat 112 par rapport au premier substrat 102 sont tels que, dans le plan passant par la première face principale 104 du premier substrat 102 à laquelle le deuxième substrat 112 est solidarisé, une projection du deuxième substrat 112 dans ce plan est entièrement incluse dans la section de cette première face principale 104 du premier substrat 102. En variante, cette projection du deuxième substrat 112 dans ce plan peut n'être que partiellement incluse dans la section de la première principale 104 du premier substrat 102. Selon une autre variante, les dimensions des faces principales 114, 116 du deuxième substrat 112 peuvent être sensiblement égales à celles des faces principales 104, 106 du premier substrat 102.

Dans le premier mode de réalisation précédemment décrit, la couche 110 servant à former l'interface de collage entre les premier et deuxième substrats 102, 112 est réalisée, préalablement à la solidarisation des deux substrats 102, 112 l'un à l'autre, en surface du premier substrat 102. De manière générale, la couche 110 servant à former l'interface de collage entre les premier et deuxième substrats 102, 112 peut être réalisée, préalablement à la solidarisation des deux substrats 102, 112, sur au moins une partie de la surface du premier substrat 102 et/ou sur au moins une partie de la surface du deuxième substrat 112, et cela indépendamment des dimensions des substrats 102, 112.

Dans le premier mode de réalisation précédemment décrit, les trous 108 sont réalisés à travers le premier substrat 102. En variante, il est possible de solidariser les substrats 102, 112 l'un à l'autre en omettant de réaliser ces trous 108 à travers le premier substrat 102. Dans ce cas, la séparation des substrats 102, 112 s'effectue grâce à une infiltration du flux de la chaleur humide qui s'effectue essentiellement au niveau des flancs latéraux de l'assemblage.

Dans le premier mode de réalisation et les variantes précédemment décrits, l'interface de collage entre les substrats 102, 110 est formée par la couche 110 comportant de l'oxyde d'aluminium. En variante, cette interface de collage peut comporter un ou plusieurs autres oxydes par exemple déposés en couches minces, et peut correspondre notamment à un empilement de couches.

Par exemple, l'interface de collage peut être formée en déposant sur le premier substrat 102 ou le deuxième substrat 112, une couche 110 d'oxyde de zirconium d'épaisseur par exemple égale à environ 10 nm par ALD à partir d'une combinaison séquentielle de précurseurs organométallique de type tetrakis(dimethylamide)zirconium (TDMAZ) et de vapeur d'eau (H₂O). Le procédé de dépôt est similaire à celui précédemment décrit pour la couche d'oxyde d'aluminium, le précurseur organométallique TMA étant remplacé par du TDMAZ et la couche d'oxyde de zirconium étant obtenue en mettant en œuvre environ 100 cycles de dépôt. Dans ces conditions, la couche de ZrO₂ obtenue à une température d'environ 80°C est amorphe avec une densité de l'ordre de 5.9 g/cm³, une rugosité de surface inférieure à environ 0,5 nm RMS et une teneur en hydrogène de l'ordre de 10 % (pourcentage atomique).

D'une manière générale, il est possible que l'interface de collage soit constituée d'une alternance de plusieurs oxydes remplissant les conditions nécessaires pour le collage des éléments 102, 112 et le démontage par exposition à un traitement thermique apte à dégrader ces oxydes (par exemple grâce à une atmosphère humide).

En outre, une solution alternative ou complémentaire pour dégrader la couche d'oxyde 110 et séparer les substrat 102, 112 l'un de l'autre, notamment lorsque l'un de ces deux substrats correspond à un substrat fragile de verre d'épaisseur inférieure ou égale à environ 100 µm et que l'autre des deux substrat correspond à un substrat rigide de verre d'épaisseur supérieure ou égale à environ 500 µm, consiste à utiliser une source lumineuse laser. Dans ce cas, l'assemblage des deux substrats 102, 112 est par exemple obtenu en déposant sur le premier substrat 102 rigide une première couche métallique 210, par exemple une couche de platine ayant une épaisseur de quelques nanomètres et destinée à réfléchir le rayonnement laser, et une deuxième couche 310 transparente vis-à-vis du rayonnement laser destiné à être utilisé pour désolidariser les deux substrats 102, 112, cette deuxième couche 310 comportant par exemple de l'alumine Al₂O₃ et une épaisseur de quelques nanomètres. L'assemblage obtenu selon ce troisième mode de réalisation est représenté schématiquement sur la figure 8.

Pour séparer les substrats 102, 112 dans la configuration telle que représentée sur la figure 8, une irradiation par laser direct de l'assemblage est réalisée à travers le deuxième substrat 112 qui est transparent vis-à-vis du rayonnement laser utilisé, afin d'atteindre l'interface de collage composée du bicouche Pt 210/Al₂O₃ 310. Le laser utilisé ici émet dans l'ultraviolet et correspond par exemple à un laser à excimères émettant à une longueur d'onde de 248 nm. En raison des propriétés d'absorption différentes entre l'alumine et le platine vis-à-vis du faisceau laser, la couche d'alumine peut être démontée mécaniquement. En effet, le platine est absorbant vis-à-vis du faisceau laser utilisé

(absorption supérieure à environ 65 % à 248 nm) contrairement à l'alumine (absorption inférieure à environ 1 % à 248 nm). Une telle projection laser contrôlée conduit à un chauffage localisé engendrant une ablation de la couche d'alumine. La densité d'énergie du laser utilisé est contrôlée afin de ne pas détériorer la couche métallique en platine et permettre une ablation totale de la couche transparente en alumine.

De manière avantageuse, l'irradiation par laser peut être réalisée à travers le premier substrat 102. Dans ce cas, la couche 310 est disposée contre le premier substrat 102.

Lorsque des micro-batteries 118 sont réalisées sur le deuxième substrat 112, l'empilement des couches actives des micro-batteries 118, notamment la couche métallique formant les collecteurs de courant, peut être utilisé comme surface bloquante et/ou réfléchissante du faisceau laser. L'irradiation laser est effectuée dans ce cas à travers la face arrière du premier substrat 102, induisant une ablation de la couche transparente en alumine localisée sous les composants actifs 118.

## Revendications

1. Procédé de collage réversible entre un premier élément (102, 202.1 - 202.4) et un deuxième élément (112), comportant au moins la mise en œuvre des étapes suivantes :
a) réalisation d'au moins une couche d'oxyde (110, 310) sur au moins une première face (104) du premier élément (102, 202.1 - 202.4) et/ou sur au moins une première face (114) du deuxième élément (112) ;
b) solidarisation de la première face (104) du premier élément (102, 202.1 - 202.4) avec la première face (114) du deuxième élément (112) telle que la couche d'oxyde (110, 310) forme une interface de collage entre le premier élément (102, 202.1 - 202.4) et le deuxième élément (112) ;
c) désolidarisation du deuxième élément (112) vis-à-vis du premier élément (102, 202.1 - 202.4) par l'application d'un traitement thermique sous atmosphère humide contrôlée dégradant physiquement et/ou chimiquement la couche d'oxyde (110, 310).

2. Procédé selon la revendication 1, dans lequel :
- le premier élément (102) et/ou le deuxième élément (112) correspond à un substrat, et/ou
- le premier élément (102, 202.1 - 202.4) et/ou le deuxième élément (112) comporte du verre et/ou un semi-conducteur et/ou une céramique, et/ou
- le premier élément (102, 202.1 - 202.4) a une épaisseur supérieure ou égale à environ 500 µm, et/ou
- le deuxième élément (112) a une épaisseur inférieure à environ 500 µm.

3. Procédé selon l'une des revendications précédentes, comportant en outre, avant l'étape a), la réalisation d'au moins une ouverture (108) à travers le premier élément (102) et/ou le deuxième élément (112).

4. Procédé selon l'une des revendications précédentes, comportant en outre, entre les étapes b) et c), la mise en œuvre d'une étape de traitement du premier élément (102, 202.1 - 202.2) et/ou du deuxième élément (112).

5. Procédé selon la revendication 4, dans lequel :
- l'étape de traitement comporte la réalisation d'au moins une partie d'au moins un dispositif microélectronique (118) sur le deuxième élément (112) et/ou sur le premier élément (102), et/ou
- l'étape de traitement est mise en œuvre à une température supérieure ou égale à environ 400°C.

6. Procédé selon la revendication 5, dans lequel le dispositif microélectronique (118) réalisé correspond à un dispositif de stockage d'énergie et/ou un dispositif de récupération d'énergie et/ou un dispositif d'affichage et/ou un capteur et/ou un actionneur.

7. Procédé selon l'une des revendications précédentes, dans lequel la couche d'oxyde (110, 310) :
- comporte de l'oxyde d'aluminium et/ou de l'oxyde de titane et/ou de l'oxyde de zirconium et/ou de l'oxyde de zinc et/ou de l'oxyde de silicium, et/ou
- est déposée sur toute les surfaces du premier élément (102, 202.1 - 202.4) et/ou du deuxième élément (112), et/ou
- a une épaisseur inférieure ou égale à environ 100 nm, et/ou
- est déposé par dépôt de couches atomiques à partir d'au moins un précurseur organométallique et un précurseur comportant des molécules d'eau.

8. Procédé selon l'une des revendications précédentes, dans lequel le traitement thermique comporte un chauffage par rayonnement laser de la couche d'oxyde (110, 310).

9. Procédé selon la revendication 8, dans lequel le traitement thermique comporte un chauffage par rayonnement laser de la couche d'oxyde (110, 310) à travers l'un des premier et deuxième éléments (102, 202.1 - 202.4, 112) ledit un des premier et deuxième éléments (102, 202.1 - 202.4, 112) étant transparent vis-à-vis du rayonnement laser.

10. Procédé selon la revendication 9, dans lequel l'autre des premier et deuxième éléments (102, 202.1 - 202.4, 112) comporte au moins une couche (126, 210) apte à réfléchir et/ou absorber le rayonnement laser.

11. Procédé selon l'une des revendications précédentes, comportant en outre :
- avant l'étape b), la mise en œuvre d'un traitement plasma, et/ou
- entre les étapes b) et c), la mise en œuvre d'un traitement thermique renforçant l'énergie de collage entre le premier élément (102, 202.1 - 202.4) et le deuxième élément (112), et/ou
- avant l'étape c), l'application d'un champ électrostatique sur le premier élément (102, 202.1 - 202.4) et/ou le deuxième élément (112).

12. Procédé selon la revendication 11, dans lequel le traitement thermique renforçant l'énergie de collage entre le premier élément (102, 202.1 - 202.4) et le deuxième élément (112) est mis en œuvre à une température inférieure à environ 400°C.

13. Procédé selon l'une des revendications précédentes, dans lequel la désolidarisation du deuxième élément (112) vis-à-vis du premier élément (102, 202.1 - 202.4) comporte en outre l'application d'une action mécanique et/ou d'un jet de gaz sous pression entre les premier et deuxième éléments (102, 202.1 - 202.4, 112).

14. Procédé selon l'une des revendications précédentes, dans lequel les dimensions de la première face (104) du premier élément (102) sont supérieures ou égale à celles de la première face (114) du deuxième élément (112).

## Patentansprüche

1. Verfahren zum reversiblen Verkleben zwischen einem ersten Element (102, 202.1- 202.4) und einem zweiten Element (112), das zumindest die Ausführung der folgenden Schritte umfasst:
a) Erzeugen mindestens einer Oxidschicht (110, 310) auf mindestens einer ersten Seite (104) des ersten Elements (102, 202.1- 202.4) und/oder auf mindestens einer ersten Seite (114) des zweiten Elements (112);
b) Verbinden der ersten Seite (104) des ersten Elements (102, 202.1 - 202.4) mit der ersten Seite (114) des zweiten Elements (112) derart, dass die Oxidschicht (110, 310) eine Verklebungsgrenzfläche zwischen dem ersten Element (102, 202.1 -202.4) und dem zweiten Element (112) bildet;
c) Lösen des zweiten Elements (112) von dem ersten Element (102, 202.1 - 202.4) durch Anwenden einer Wärmebehandlung unter kontrollierter, feuchter Atmosphäre, wodurch die Oxidschicht (110, 310) physikalisch und/oder chemisch abgebaut wird.

2. Verfahren nach Anspruch 1, wobei:
- das erste Element (102) und/oder das zweite Element (112) einem Substrat entspricht, und/oder
- das erste Element (102, 202.1 - 202.4) und/oder das zweite Element (112) Glas und/oder einen Halbleiter und/oder eine Keramik enthält, und/oder
- das erste Element (102, 202.1 - 202.4) eine Dicke von größer oder gleich etwa 500 µm hat, und/oder
- das zweite Element (112) eine Dicke von weniger als etwa 500 µm hat.

3. Verfahren nach einem der vorhergehenden Ansprüche, ferner umfassend vor Schritt a) das Ausbilden mindestens einer Öffnung (108) durch das erste Element (102) und/oder das zweite Element (112).

4. Verfahren nach einem der vorhergehenden Ansprüche, ferner umfassend zwischen den Schritten b) und c) das Ausführen eines Schrittes der Bearbeitung des ersten Elements (102, 202.1 - 202.2) und/oder des zweiten Elements (112).

5. Verfahren nach Anspruch 4, wobei:
- der Schritt der Bearbeitung das Herstellen mindestens eines Teils mindestens einer mikroelektronischen Vorrichtung (118) an dem zweiten Element (112) und/oder an dem ersten Element (102) umfasst, und/oder
- der Schritt der Bearbeitung bei einer Temperatur größer oder gleich etwa 400°C ausgeführt wird.

6. Verfahren nach Anspruch 5, wobei die hergestellte mikroelektronische Vorrichtung (118) einer Energiespeichereinrichtung und/oder einer Energierückgewinnungseinrichtung und/oder einer Anzeigeeinrichtung und/oder einem Sensor und/oder einem Aktor entspricht.

7. Verfahren nach einem der vorhergehenden Ansprüche, wobei die Oxidschicht (110, 310)
- Aluminiumoxid und/oder Titanoxid und/oder Zirkoniumoxid und/oder Zinkoxid und/oder Siliziumoxid enthält, und/oder
- auf allen Flächen des ersten Elements (102, 202.1 - 202.4) und/oder des zweiten Elements (112) abgeschieden wird, und/oder
- eine Dicke von kleiner oder gleich etwa 100 nm hat, und/oder
- durch Atomlagenabscheidung aus mindestens einem metallorganischen Vorläufer und einem Wassermoleküle enthaltenden Vorläufer abgeschieden wird.

8. Verfahren nach einem der vorhergehenden Ansprüche, wobei die Wärmebehandlung ein Erhitzen der Oxidschicht (110, 310) durch Laserstrahlung umfasst.

9. Verfahren nach Anspruch 8, wobei die Wärmebehandlung ein Erhitzen der Oxidschicht (110, 310) durch Laserstrahlung durch eines aus erstem und zweitem Element (102, 202.1 - 202.4, 112) hindurch umfasst, wobei eines aus erstem und zweitem Element (102, 202.1 - 202.4, 112) für die Laserstrahlung transparent ist.

10. Verfahren nach Anspruch 9, wobei das andere aus erstem und zweitem Element (102, 202.1 - 202.4, 112) mindestens eine Schicht (126, 210) enthält, die Laserstrahlung reflektieren und/oder absorbieren kann.

11. Verfahren nach einem der vorhergehenden Ansprüche, ferner umfassend:
- vor Schritt b), Durchführen einer Plasmabehandlung, und/oder
- zwischen den Schritten b) und c), Durchführen einer Wärmebehandlung, wodurch die Haftkraft zwischen dem ersten Element (102, 202.1 - 202.4) und dem zweiten Element (112) verstärkt wird, und/oder
- vor Schritt c), Anlegen eines elektrostatischen Feldes an das erste Element (102, 202.1 - 202.4) und/oder das zweite Element (112).

12. Verfahren nach Anspruch 11, wobei die die Haftkraft zwischen dem ersten Element (102, 202.1 - 202.4) und dem zweiten Element (112) verstärkende Wärmebehandlung bei einer Temperatur unter etwa 400°C durchgeführt wird.

13. Verfahren nach einem der vorhergehenden Ansprüche, wobei das Lösen des zweiten Elements (112) von dem ersten Element (102, 202.1 - 202.4) ferner das Anwenden einer mechanischen Einwirkung und/oder eines Druckgasstrahls zwischen dem ersten und dem zweiten Element (102, 202.1 - 202.4, 112) umfasst.

14. Verfahren nach einem der vorhergehenden Ansprüche, wobei die Abmessungen der ersten Seite (104) des ersten Elements (102) größer oder gleich denen der ersten Seite (114) des zweiten Elements (112) sind.

## Claims

1. Method for reversible bonding between a first element (102, 202.1 - 202.4) and a second element (112), comprising at least the implementation of the following steps:
a) producing at least one oxide layer (110, 310) on at least one first face (104) of the first element (102, 202.1 - 202.4) and/or on at least one first face (114) of the second element (112);
b) joining the first face (104) of the first element (102, 202.1 - 202.4) with the first face (114) of the second element (112) such that the oxide layer (110, 310) forms a bonding interface between the first element (102, 202.1 - 202.4) and the second element (112);
c) disjoining the second element (112) with regard to the first element (102, 202.1 - 202.4) by the application of a heat treatment under controlled humid atmosphere physically and/or chemically degrading the oxide layer (110, 310).

2. Method according to claim 1, wherein:
- the first element (102) and/or the second element (112) corresponds to a substrate, and/or
- the first element (102, 202.1 - 202.4) and/or the second element (112) comprises glass and/or a semiconductor and/or ceramic, and/or
- the first element (102, 202.1 - 202.4) has a thickness greater than or equal to around 500 µm, and/or
- the second element (112) has a thickness less than around 500 µm.

3. Method according to one of previous claims, further comprising, before step a), the formation of at least one opening (108) through the first element (102) and/or the second element (112).

4. Method according to one of previous claims, further comprising, between steps b) and c), the implementation of a step of treating the first element (102, 202.1 - 202.2) and/or the second element (112).

5. Method according to claim 4, wherein:
- the treatment step comprises the production of at least one part of at least one microelectronic device (118) on the second element (112) and/or on the first element (102), and/or
- the treatment step is implemented at a temperature greater than or equal to around 400°C.

6. Method according to claim 5, wherein the microelectronic device (118) produced corresponds to an energy storage device and/or an energy recovery device and/or a display device and/or a sensor and/or an actuator.

7. Method according to one of previous claims, wherein the oxide layer (110, 310):
- comprises aluminium oxide and/or titanium oxide and/or zirconium oxide and/or zinc oxide and/or silicon oxide, and/or
- is deposited over the entire surfaces of the first element (102, 202.1 - 202.4) and/or of the second element (112), and/or
- has a thickness less than or equal to around 100 nm, and/or
- is deposited by deposition of atomic layers from at least one organometallic precursor and a precursor comprising water molecules.

8. Method according to one of previous claims, wherein the heat treatment comprises a heating by laser radiation of the oxide layer (110, 310).

9. Method according to claim 8, wherein the heat treatment comprises a heating by laser radiation of the oxide layer (110, 310) through one of the first and second elements (102, 202.1 - 202.4, 112) said one of the first and second elements (102, 202.1 - 202.4, 112) being transparent with regard to the laser radiation.

10. Method according to claim 9, wherein the other of the first and second elements (102, 202.1 - 202.4, 112) comprises at least one layer (126, 210) capable of reflecting and/or absorbing the laser radiation.

11. Method according to one of previous claims, further comprising:
- before step b), the implementation of a plasma treatment, and/or
- between steps b) and c), the implementation of a heat treatment reinforcing the bonding energy between the first element (102, 202.1 - 202.4) and the second element (112), and/or
- before step c), the application of an electrostatic field on the first element (102, 202.1 - 202.4) and/or the second element (112).

12. Method according to claim 11, wherein the heat treatment reinforcing the bonding energy between the first element (102, 202.1 - 202.4) and the second element (112) is implemented at a temperature less than around 400°C.

13. Method according to one of previous claims, wherein the disjoining of the second element (112) with regard to the first element (102, 202.1 - 202.4) further comprises the application of a mechanical action and/or of a jet of pressurised gas between the first and second elements (102, 202.1 - 202.4, 112).

14. Method according to one of previous claims, wherein the dimensions of the first face (104) of the first element (102) are greater than or equal to those of the first face (114) of the second element (112).
